# EUROPÄISCHE PATENTSCHRIFT

(11) **EP 2 068 344 B1**
(45) Veröffentlichungstag und Bekanntmachung des Hinweises auf die Patenterteilung: **21.10.2015**
(21) Anmeldenummer: 08020365.6
(22) Anmeldetag: 22.11.2008
(51) Int. Cl.: H01J 37/153, H01J 37/26

(54) **Teilchenoptischer Korrektor für axialen und ausseraxialen Strahlengang**
Particle optical corrector for axial and off-axis beam path
Correcteur optique à particules pour trajectoire de faisceau axiale et hors axe

(30) Priorität: 05.12.2007 DE 102007058443
(43) Veröffentlichungstag der Anmeldung: 10.06.2009
(73) Patentinhaber: Ceos Corrected Electron Optical Systems GmbH, 69126 Heidelberg (DE)
(72) Erfinder: Zach, Joachim, Dr., 76684 Östringen (DE); Rose, Harald, Prof., Dr., 64287 Darmstadt (DE)
(74) Vertreter: Weber & Seidel

(56) Entgegenhaltungen:
- EP-A1- 1 381 073
- WO-A1-2007/065382
- KRIVANEK O L ET AL: "Towards sub-0.5 A electron beams", ULTRAMICROSCOPY, ELSEVIER, AMSTERDAM, NL, Bd. 96, Nr. 3-4, 1. September 2003 (2003-09-01), Seiten 229-237, XP002582176, ISSN: 0304-3991, DOI: 10.1016/S0304-3991(03)00090-1 [gefunden am 2003-05-16]

## Beschreibung

Die Erfindung betrifft einen Korrektor für den axialen und außeraxialen Strahlengang eines teilchenoptischen Systems mit einem ersten und einem zweiten Korrekturstück, die im Strahlengang auf einer optischen Achse nacheinander angeordnet sind, wobei jedes Korrekturstück vier nacheinander angeordnete Multipolelemente mit den folgenden Feldern in einer Symmetrie zu einer Mittelebene aufweist, wobei von den Multipolelementen das erste und das vierte zur Erzeugung von Quadrupolfeldern und das zweite und dritte zur Erzeugung von Oktupolfeldern und von Quadrupolfeldern dienen, wobei letztere übereinandergelagerte magnetische und elektrische Felder sind und wobei die Quadrupolfelder aller vier Multipolelemente von einem zum nächsten um 90° gedreht sind, so daß mittels astigmatischer Zwischenbilder im zweiten und dritten Multipolelement durch das Zusammenwirken der magnetischen und elektrischen Felder eine Farbfehlerkorrektur und mittels der Quadrupolfelder und der Oktupolfelder eine Öffnungsfehlerkorrektur möglich ist. Die Erfindung betrifft weiterhin ein Transmissionselektronenmikroskop mit einem derartigen Korrektor.

Teilchenoptische System haben gegenüber der Lichtoptik den Vorteil, daß sie durch die kleinere Wellenlänge von Elektronen und Ionen über eine wesentlich bessere Auflösung verfügen. Dem Erreichen der theoretisch möglichen Auflösungsgrenze von einer halben Wellenlänge steht entgegen, daß die verwendeten Linsen, die mit magnetischen oder elektrischen Feldern arbeiten, mit zahlreichen Linsenfehlern behaftet sind.

Derartige Linsenfehler sind unterteilt in Farbfehler und geometrische Bildfehler. Die Farbfehler entstehen dadurch, daß die abbildenden Elektronen oder Ionen unterschiedliche Geschwindigkeiten und damit unterschiedliche Wellenlängen aufweisen. Diese kommen vorwiegend dadurch zustande, daß die für die Erzeugung des Strahls emittierten Elektronen (oder Ionen) eine gewisse Energiestrahlbreite aufweisen.

Die geometrischen Bildfehler sind größtenteils auf die ungenaue Abbildung durch die elektromagnetischen Felder, welche der Laplacegleichung gehorchen müssen, zurückzuführen. So entstehen Öffnungsfehler, wenn die Brennweite der äußeren Linsenzonen kleiner ist, als die der inneren Linsenzonen. Dies hat zur Folge, daß ein Punkt in der Bildebene nicht mehr als Punkt abgebildet wird. Eine weitere Fehlerquelle besteht darin, daß die Linsen nicht völlig symmetrisch sind und dadurch die Linsenstärken in zwei zur optischen Achse senkrechten Richtungen unterschiedlich sind. Dieser Fehler wird als Astigmatismus bezeichnet. Es gibt noch eine Reihe weiterer Bildfehler, deren Ursache nicht in allen Fällen bekannt ist.

Bildfehler treten zum einen als axiale Bildfehler bei der Abbildung eines Achspunktes auf. Der Strahlenverlauf zur Abbildung desselben wird bestimmt durch den Verlauf der von dem Achspunkt der Gegenstandsebene ausgehenden in x- und y-Schnitten liegenden axialen Fundamentalbahnen x_{α} und y_{β}. Zum anderen treten Bildfehler auch als außeraxiale Bildfehler bei der Abbildung eines außeraxialen Bildpunktes auf. Der Strahlenverlauf zur Abbildung desselben wird bestimmt durch den Verlauf der von einem achsfernen Punkt der Gegenstandsebene ausgehenden, im x- und y-Schnitt liegenden außeraxialen Fundamentalbahnen x_{γ} und y_{δ}.

Durch das Beugungsverhalten der Strahlen treten diese Fehler in mehreren Ordnungen auf. Dabei sind die geometrischen Bildfehler als die Achse umgebende charakteristische Fehlerfiguren sichtbar. Diese treten beispielsweise von der zweiten bis zur fünften Ordnung als folgende Fehler auf: 2. Ordnung: Dreizähliger axialer Astigmatismus, axiale Koma., 3. Ordnung: Vierzähliger axialer Astigmatismus, Öffnungsfehler, axialer Sternfehler, 4. Ordnung: fünfzähliger axialer Astigmatismus, axiale Koma, axialer Dreilappfehler, 5. Ordnung: sechszähliger axialer Astigmatismus, Öffnungsfehler, axialer Sternfehler, axialer Rosettenfehler, ... usw. Die Zähligkeit gibt dabei die Sternecken der Bildfehlerfigur an. Bei Fehlern ab der 4. Ordnung spricht man von Fehlern höherer Ordnung.

Verursacht werden die geometrischen Bildfehler vorwiegend durch die Objektivlinse, jedoch auch durch andere Linsen und auch durch den Korrektor selbst. Korrigiert werden diese Fehler durch den Korrektor sowohl als Nachkompensation, als auch als Vorkompensation, wobei sich die Korrekturmaßnahme immer am Ergebnis des Endbildes orientiert.

Die Grundlage für die Korrektur der axialen Bildfehler bildet die Erkenntnis von O. Scherzer (0. Scherzer: "Sphärische und chromatische Korrektur von Elektronen-Linsen" OPTIK, DE, JENA, 1947, Seiten 114-132, XP002090897, ISSN: 0863-0259), daß bei Teilchenstrahlen die Korrektur von sphärischen (also geometrischen) und chromatischen (also Farbfehlern) möglich ist, wenn man nicht-rotationssymmetrische Felder einsetzt. Dabei werden astigmatische Zwischenbilder erzeugt und dort die Korrektur nacheinander in einem Zwischenbild in der x-Ebene, dann in einem Zwischenbild in der dazu senkrechten y-Ebene vorgenommen. Danach wird eine Unrundheit des Strahls wieder beseitigt, indem er wieder zu einem runden Strahl vereinigt wird. O. Scherzer stellt die Bedingungen auf, unter denen diese Korrekturen erreichbar sind (a.a.O.). Diese als Scherzer-Theorem bezeichneten Bedingungen sind Grundlage jeder Fehlerkorrektur im axialen Bereich in der Teilchenoptik. Die Korrektur der außeraxialen Fehler bedarf keiner astigmatischen Zwischenbilder, sie kann mit Rund- oder Multipolfeldern erfolgen.

Die Korrektur von unrunden Fehlern, wie des Astigmatismuses, bedarf eines unrunden Feldes, um beispielsweise beim Astigmatismus den Strahl wieder in seinen runden Querschnitt zurückzubringen oder um bei sonstigen unrunden Fehlern der verursachenden Unrundheit entgegenzuwirken.

Ausgehend von diesen Grundlagen wurde von Rose (Optik, Band 34, 1971, Seiten 285 - 311, insbesondere bis 293) ein Korrektor der eingangs genannten Art vorgeschlagen, mit dem eine relativ weitreichende Fehlerkorrektur erzielt werden konnte und der Korrektor selbst nahezu keine Fehler verursacht. Dabei wurde jedoch dieser Korrektor nicht weiter untersucht, da er gegenüber anderen dort gemachten Vorschlägen Nachteile aufweisen würde. Insbesondere ist mit dem Korrektor der eingangs genannten Art der Astigmatismus 3. Ordnung nur schlecht zu beseitigen, insbesondere nicht ohne Fehler höherer Ordnung zu erzeugen.

Der Erfindung liegt daher die Aufgabe zugrunde, auch den Astigmatismus 3. Ordnung zu beseitigen, ohne störende Fehler höherer Ordnung einzuführen. Darüber hinaus sollen zusätzliche Maßnahmen getroffen werden, um durch Beseitigung von Fehlern bis zu hohen Ordnungen eine befriedigende Bildauflösung bis zu etwa 5000 Bildpunkte längs eines Bilddurchmessers zu erzielen.

Die Aufgabe wird erfindungsgemäß dadurch gelöst, daß ein in der Mittelebene liegendes zentrales Multipolelement ein Oktupolfeld zur Beseitigung des Astigmatismuses 3. Ordnung erzeugt.

Dadurch, daß sich mittels des Oktupolfeldes des zentralen Multipolfeldes auch der Astigmatismus 3. Ordnung beseitigen läßt, ist der Korrektor durch entsprechende Einstellung der genannten Quadrupol- und Oktupolfelder in der Lage, sowohl die Fehler der Objektivlinse, anderer Linsen, als auch durch ihn selbst verursachte Fehler bis in höhere Ordnungen weitestgehend zu beseitigen oder diese erst gar nicht entstehen zu lassen. Mit Hilfe von weiteren den Unteransprüchen entnehmbaren Ausgestaltungen können noch weitere Verbesserungen erzielt werden.

Alle Felder der beiden Korrekturstücke sowie des zentralen Multipolelements mit Ausnahme der Quadrupolfelder des zweiten und dritten Multipolelements der beiden Korrekturstücke können dabei magnetische oder elektrische Felder oder eine Kombination von beidem sein.

Korrektoren, die unter anderem auch den Astigmatismus dritter Ordnung korrigieren, sind aus den Dokumenten WO-A-2007/065382 und EP-A-1381073 bekannt.

Der erfindungsgemäße Korrektor geht zunächst von den vorbekannten Funktionen aus, daß nach der Lehre von O. Scherzer (a.a.O.) das Quadrupolfeld des ersten Multipolelements dem Strahl eine Abweichung von der Rotationssymmetrie aufprägt, so daß in zwei aufeinander senkrechten Hauptschnitten, dem x- und dem y-Schnitt, die Fundamentalbahnen x_{α} und y_{β} unterschiedlich divergierend verlaufen. Dabei stellen diese Fundamentalbahnen x_{α} und y_{β} die äußeren Begrenzungen der axialen Strahlen in der x- und y-Ebene dar. Das nachfolgende, um 90° gedrehte Quadrupolfeld des zweiten Multipolelements kann nur den Strahl eines Schnittes, beispielsweise des x-Schnitts, beeinflussen, der keinen Nulldurchgang hat, nicht dagegen den Teil des Strahls, der an dieser Stelle einen Nulldurchgang aufweist (y-Schnitt). Dieser Strahl (x-Schnitt) wird dabei derart umgelenkt, daß er parallel zum Strahl des anderen Schnitts (y-Schnitts), verläuft. Dieselbe Umlenkung erfährt im wiederum um 90° gedrehten Quadrupolfeld des dritten Multipolelements der andere Strahlteil, so daß sich die Strahlen der senkrecht aufeinanderstehenden Hauptschnitte wieder aufeinander zubewegen, um dann durch das Quadrupolfeld des vierten Multipolelements wieder zu einem runden Strahlenbündel vereinigt zu werden. Die genannten Abweichungen von der Rotationssymmetrie dienen der Farb- und Öffnungsfehlerkorrektur nach dem Scherzer-Theorem (a,a.O.).

Die praktische Realisierung der Korrektur der axialen Fehler sieht zunächst vor, daß die Farbfehlerkorrektur bezüglich eines Schnittes, beispielsweise des x-Schnittes, mit dem zweiten Multipolelement des ersten Korrekturstücks und dem dritten Multipolelement des zweiten Korrekturstücks erfolgt. Bezüglich des anderen Schnittes, beispielsweise des y-Schnittes, mit dem dritten Multipolelement des ersten Korrekturstücks und dem zweiten Multipolelement des zweiten Korrekturstücks. Die Korrektur findet somit im Bereich der vier astigmatischen Zwischenbilder des Korrektors statt. Die Funktion der Farbfehlerkorrektur entspricht dem bekannten Wienfilter und beruht darauf, daß die Quadrupolfelder aus sich überlagernden elektrischen und magnetischen Quadrupolfeldern bestehen. Die Feldstärken sind dabei so ausgelegt, daß Elektronen einer bestimmten Geschwindigkeit - also einer bestimmten Energie und in Relation zur Lichtoptik einer bestimmten Farbe - die Felder auf ihrem vorbestimmten Weg passieren. Die Elektronen abweichender Energien verlassen den vorbestimmten Weg, und damit ist es möglich, den Farbfehler der Rundlinsen des Mikroskops, insbesondere der Objektivlinse, gegenzukompensieren. Nur für diese Farbfehlerkorrektur ist daher die Kombination aus elektrischem und magnetischem Feld erforderlich. Die Korrektur wird dabei je zur Hälfte im ersten und zweiten Korrekturstück vorgenommen.

Bezüglich der Öffnungsfehler erfolgt die Korrektur ebenfalls in den astigmatischen Zwischenbildern, also in den zweiten und dritten Multipolelementen eines jeden Korrekturstücks mittels deren Oktupolfelder. Die Öffnungsfehler kommen von den rotationssymmetrischen Linsen teilchenoptischer Systeme, da diese in größerer Entfernung von der optischen Achse verlaufende Strahlen stärker beeinflussen. Dies führt dazu, daß die Strahlen im Bereich von Zwischenbildern keinen gemeinsamen Schnittpunkt mit der optischen Achse bilden. Im Bereich der astigmatischen Zwischenbilder lassen sich die Strahlen des jeweiligen Schnittes, der keinen Nulldurchgang hat, durch die Oktupolfelder derart beeinflussen, daß sich die Strahlen wieder in der Bildebene schneiden. Wird die Korrektur für die Strahlen eines jeden Schnittes nacheinander durchgeführt und diese Strahlen dann wieder zu einem runden Strahl zusammengeführt, ist die Öffnungsfehlerkorrektur erfolgt. Dabei ist es jedoch nicht nur möglich, Öffnungsfehler vorgeordneter Rundlinsen zu korrigieren, es können auch Fehler nachgeordneter Rundlinsen vorkompensiert werden. Dann wird dem Strahlengang ein derartiger Öffnungsfehler aufgeprägt, daß er sich mit den Öffnungsfehlern der nachgeordneten Rundlinsen, beispielsweise des Objektivs, wieder aufhebt. Auch hier erfolgt die Fehlerkorrektur je zur Hälfte im ersten und zweiten Korrekturstück, wobei insbesondere der Öffnungsfehler 3. Ordnung sukzessive durch die Oktupolfelder des ersten und die Oktupolfelder des zweiten Korrekturelements abgebaut wird.

Bezüglich der außeraxialen Strahlen, deren Begrenzung in der x- und y-Ebene durch die Fundamentalbahnen x_{γ} und y_{δ} gezeigt werden, bewirkt der erste Quadrupol ebenfalls eine Abweichung von der Rotationssymmetrie, der zweite Quadrupol eine Umlenkung der Strahlen der einen Ebene, der dritte Quadrupol die Umlenkung der Strahlen in der anderen Ebene und der vierte Quadrupol die Zusammenführung wieder zu einem runden Strahl. Zwischenbilder entstehen hier jedoch keine.

Dadurch, daß das zweite Korrekturstück dem ersten entspricht, jedoch die Multipolelemente in umgekehrter Reihenfolge angeordnet sind, findet sich dort das eben beschriebene wieder, wobei der axiale Strahlengang (x_{α} und y_{β}) symmetrisch, also spiegelbildlich verläuft, und der außeraxiale Strahlengang (x_{γ} und y_{δ}) antisymmetrisch, also punktsymmetrisch. Dadurch, daß die Korrekturstücke zur Mittelebene symmetrisch aufgebaut sind und die außeraxialen Fundamentalbahnen antisymmetrisch verlaufen, verursacht der Korrektor selbst im Wesentlichen keine geometrischen optischen Fehler im außeraxialen Bereich. Der Grund besteht darin, daß die im ersten Korrekturstück verursachten außeraxialen Fehler durch die - aufgrund der Symmetrie der Anordnung der Felder - entgegengesetzte Wirkung des zweiten Korrekturstücks wieder eliminiert werden. Eine Ausnahme bilden hier jedoch Fehlerkurven, die nicht symmetrisch beziehungsweise antisymmetrisch um die Mittelebene durch den Korrektor verlaufen und ihrerseits wieder Fehler (höherer Ordnung) erzeugen.

Was noch verbleibt, sind die axialen Fehler, welche von dem optischen System, in das der Korrektor eingeordnet ist, oder vom Korrektor selbst verursacht werden. Am schwerwiegendsten ist dabei ein Astigmatismus 3. Ordnung, der durch die Öffnungsfehlerkorrektur im Korrektor erzeugt wird.

Der Grundgedanke der Erfindung besteht darin, diesen durch die Anordnung eines Multipolelements zur Erzeugung eines Oktupolfeldes zu beseitigen, wobei die Anordnung in der Mittelebene, in der beide außeraxiale Fundamentalbahnen x_{γ} und y_{δ} durch Null gehen, dafür sorgt, daß dieses Multipolelement selbst keinerlei neue außeraxialen Fehler verursacht.

Weiterbildungen des Korrektors dienen der Beseitigung weiterer Fehler höherer Ordnungen.

Der in oben genannter Weise korrigierte Öffnungsfehler 3. Ordnung ist beispielsweise eine der o.g. Ausnahmen einer Fehlerverursachung im Korrektor durch eine nicht symmetrisch oder antisymmetrisch verlaufende Fehlerkurve. Dieser Öffnungsfehler 3. Ordnung verursacht dort, wo er noch groß ist, und wo Oktupole liegen, axiale Fehler 5. Ordnung. Da die Korrektur des Öffnungsfehlers 3. Ordnung in oben genannter Weise sukzessive erfolgt, können sich die Fehlerverursachung im ersten Korrekturstück mit der entsprechenden Fehlerverursachung im zweiten Korrekturstück nicht aufheben. Bei diesen axialen Fehlern 5. Ordnung handelt es sich um vier Fehler: Einen Öffnungsfehler, einen Sternfehler, einen Rosettenfehler und einen Astigmatismus (jeweils 5. Ordnung). Darum wird vorgeschlagen, daß zur Korrektur der Fehler 5. Ordnung mittels der zweiten und dritten Multipolelemente des ersten Korrekturstücks sowie des zentralen Multipolelements Zwölfpolfelder erzeugt werden. Diese Anordnung im ersten Korrekturstück und im zentralen Multipolelement ist für diese Korrektur dreier dieser vier Fehler ausreichend. Dabei kann mittels eines jeden Zwölfpols jeweils einer dieser vier Fehler korrigiert werden. Die nachfolgend im zweiten Korrekturstück im wesentlich geringeren Maß verursachten Öffnungsfehler 5. Ordnung werden in diese Kompensation mit einbezogen, so daß die Fehler bei der Bilderzeugung eliminiert sind.

Zweckmäßigerweise werden mit diesen Zwölfpolfeldern der Sternfehler 5. Ordnung, der Rosettenfehler 5. Ordnung und der Astigmatismus 5. Ordnung korrigiert. Der Grund dafür, daß diese drei Fehler für die Korrektur ausgewählt werden, ist der, daß die Korrektur dieser unrunden Fehler des Einsatzes unrunder Felder bedarf. Der Öffnungsfehler 5. Ordnung kann auch mittels eines runden Feldes korrigiert werden, dazu wird weiter unten noch ein Vorschlag gemacht.

Als noch vorhandener außeraxialer Fehler tritt noch eine Koma der als magnetische Linse ausgebildeten Objektivlinse auf. Diese Koma tritt als isotrope und als anisotrope Koma auf, wobei die isotrope Koma im Wesentlichen kein Problem darstellt, da sie mittels einer geeigneten Erregung der Rundlinsen beseitigbar ist. Darum beschränkt sich eine Weiterbildung darauf, daß zur Korrektur der anisotropen Koma der Objektivlinse mittels aller Multipolelemente, welche die Quadrupolfelder erzeugen weitere Oktupolfelder erzeugt werden, die gegenüber den oben genannten Oktupolfeldern der Öffnungsfehlerkorrektur um 22,5° verdreht sind und wobei die Oktupolfeldstärken bezüglich der Symmetrieebenen der Korrekturstücke und bezüglich der Mittelebene antisymmetrisch sind. Dabei sind diese weiteren Oktupolfelder gegeneinander alle in der gleichen Lage.

Um die verschiedenen Felder durch die vorgesehenen Multipolelemente erzeugen zu können, ist es zweckmäßig, daß mindestens die zweiten und dritten Multipolelemente des ersten und zweiten Korrekturstücks und das zentrale Multipolelement Zwölfpolelemente sind, welche durch eine Steuerung unterschiedliche Felder bis zu Zwölfpolfeldern, einschließlich Überlagerungen unterschiedlicher Felder, durch entsprechende Strom- und/oder Spannungsbeaufschlagung erzeugen können. Dies wird noch anhand einer Darstellung in der Zeichnungsbeschreibung erläutert.

Die Charakterisierung von Feldern des Korrektors dahingehend, daß Einstellungen und Justierungen beziehungsweise Nachjustierungen zur Fehlerbeseitigung möglich sind, bedeutet daher folgendes: Die baulichen Ausgestaltungen von Elektroden und/oder Elektromagneten und deren Beaufschlagungsmöglichkeit mit Strom beziehungsweise Spannung muß derart sein, daß nach dem Einbau des Korrektors in ein teilchenoptisches System, beispielsweise in ein Elektronenmikroskop die angegebenen Korrekturmaßnahmen möglich sind. Durchgeführt werden diese Einstellungen, Justierungen und Nachjustierungen nach dem Einbau und der Inbetriebnahme des jeweiligen teilchenoptischen Systems, wie des Elektronenmikroskops, da die konkreten Einstellungen sowohl von dessen Bauart als auch von den individuellen Linsenfehlern abhängt, welche auch bei den Geräten der gleichen Baureihen individuell auftreten, beispielsweise durch Maßungenauigkeiten und Materialinhomogenitäten. Auch muß beim Betrieb der Geräte von Zeit zu Zeit eine Nachjustierung erfolgen, da schon geringste Verschmutzungen die optischen Eigenschaften verändern und eine solche erforderlich machen können. Realisiert ist die Erfindung in einem Korrektor, der diese Korrekturmöglichkeiten des Elektronenstrahls ermöglicht. Die Konkretisierung der baulichen Ausgestaltung des Korrektors sowie die konkret zur Verfügung gestellten Strom und/oder Spannungsbereiche, die für die Einstellungen und Korrekturen erforderlich sind, richten sich nach der Bauart des jeweiligen Gerätes, insbesondere nach den jeweiligen Strahlspannungen, der möglichen Arbeitsbereiche und der konkreten Ausgestaltung des Linsensystems.

Um auch noch den oben bereits erwähnten Öffnungsfehler 5. Ordnung beziehungsweise eine mit diesem korrelierende - wenn auch geringere - radiale Koma 3. Ordnung zu korrigieren oder auf ein tolerierbares Maß zu reduzieren, wird vorgeschlagen, daß dem Korrektor objektivseitig zwei als Rundlinsen ausgebildete Transferlinsen zugeordnet sind, durch deren Feldeinstellung Öffnungsfehler 5. Ordnung und/oder die radiale Koma 3. Ordnung beseitigbar oder auf ein tolerierbares Maß reduzierbar sind.

Diese Maßnahme führt jedoch wiederum zu Fehlern, insbesondere wird die Korrektur des Öffnungsfehlers dritter Ordnung sowie die Farbfehlerkorrektur teilweise wieder rückgängig gemacht. Deshalb ist vorgesehen, daß eine Nachjustierung der Quadrupol- und Oktupolfelder des zweiten und dritten Multipolelements des ersten und zweiten Korrekturstücks und des Oktupolfeldes des zentralen Multipolelements möglich ist, derart daß durch die vorgenannte Einstellung der Transferlinsen erneut verursachte Farbfehler erster und Öffnungsfehler dritter Ordnung wieder beseitigt werden. Bei der Nachjustierung der Quadrupolfelder müssen die magnetischen und elektrischen Felder insoweit simultan verstellt werden, daß die Farbfehlerkorrektur - wie oben beschrieben - erhalten bleibt. Ein Abweichen von dieser Simultanverstellung ist jedoch insoweit erforderlich, als ein durch die Einstellung der Transferlinsen wiederauftretender Farbfehler nachkorrigiert werden muß.

Da die Einfügung der Transferlinsen sowie jede Verstellung, wie die vorgenannte Nachjustierung, den Strahlengang wieder verändert, ist es zweckmäßig, daß auch eine Nachjustierung der Zwölfpolfelder des zweiten und dritten Multipolelements des ersten Korrektors und des Zwölfpolfeldes des zentralen Multipolelements möglich ist, um die durch die Transferlinsen und die vorgenannte Nachjustierung wiederaufgetretenen Fehler höherer, insbesondere 5. Ordnung wieder zu beseitigen. Entsprechend müssen dann auch wieder die weiteren verdrehten Oktupolfelder nachgestellt werden.

Das Problem der vorgenannten Nachjustierungen besteht darin, daß jede Maßnahme den Strahlengang wieder verändert, was Rückwirkungen dahingehend hat, daß bereits beseitigte Fehler - wenn auch abgeschwächt - wieder auftreten. Darum ist es zweckmäßig, daß eine Beseitigung der durch Fehlerkorrekturen wieder aufgetretenen Farbfehler erster und Öffnungsfehler dritter sowie Fehler höherer Ordnung durch eine Nachjustierung von Transferlinsen, Quadrupolfeldern des ersten und zweiten Korrekturstücks und Oktupolfeldern des ersten und zweiten Korrekturstücks sowie des zentralen Multipolelements, danach von Zwölfpolfeldern des ersten Korrekturstücks sowie des zentralen Multipolelements und dann der weiteren Oktupolfelder aller Quadrupolfelder erzeugenden Multipolelemente sowie eine iterative Einstellung in den vorgenannten Schritten zur Verminderung der durch die jeweils vorangegangenen Nachjustierungen wiederum verursachten Fehler möglich sind, bis diese auf eine für die gewünschte Bildgebung tolerierbare Größe reduziert sind. Durch diese iterative Einstellung kann man sich einem Optimum natürlich nur annähern, erreichbar ist es nicht. Wenn die Restfehler jedoch so minimiert sind, daß sie die Bildgebung nicht mehr stören, ist das Ziel erreicht.

Insbesondere für den Einsatz des Korrektors in Systemen zur Bilderzeugung, wie Elektronenmikroskopen, kann es zweckmäßig sein, daß durch Zulassung eines kleinen Öffnungsfehlers 5. Ordnung eine Bildauflösung bis zu etwa 10.000 Bildpunkten längs eines Bilddurchmessers erzielbar ist.

Haupteinsatzgebiet des Korrektors sind Transmissionselektronenmikroskope, da dort Strahlen relativ großen Durchmessers zum Einsatz kommen und deshalb der Korrektur auch des außeraxialen Strahlengangs eine hohe Bedeutung zukommt. Dabei orientiert sich das Maß der Fehlerbeseitigung oder auch -tolerierung an der gewünschten Bildauflösung oder an der gewünschten Bildgröße. Für eine hohe Bildauflösung müssen Fehler weitgehender beseitigt werden, jedoch bei einer kleineren Bildgröße. Bei großer Bildgröße können dagegen Restfehler und damit eine geringere Auflösung toleriert werden.

Durch die Erfindung einschließlich ihrer Weiterbildungen kann ein korrigiertes System erzielt werden, das axial keine Fehler bis zur 6. Ordnung hat und die Fehler 7. Ordnung sowie die außeraxialen Fehler in tolerierbarem Maß klein sind.

Die nachfolgende Zeichnung beinhaltet schematische Darstellungen, sowie Feld- und Bahnverläufe zur Veranschaulichung der Erfindung. Es zeigen
- **Fig. 1**: eine Prinzipdarstellung des erfindungsgemäßen Korrektors,
- **Fig. 2**: die zu Fig. 1 korrespondierenden Bahn- und Feldverläufe,
- **Fig. 3**: Bahn- und Feldverläufe gem. Fig. 2 mit zusätzlichen Zwölfpolfeldern,
- **Fig. 4**: Bahn- und Feldverläufe gem. Fig. 2 mit zusätzlichen Oktupolfeldern,
- **Fig. 5**: eine Prinzipdarstellung eines Elektronenmikroskops und
- **Fig. 6**: eine Prinzipdarstellung eines Multipolelements mit zwölf Polen.

### Alle Darstellungen erfolgen nach folgender Systematik:

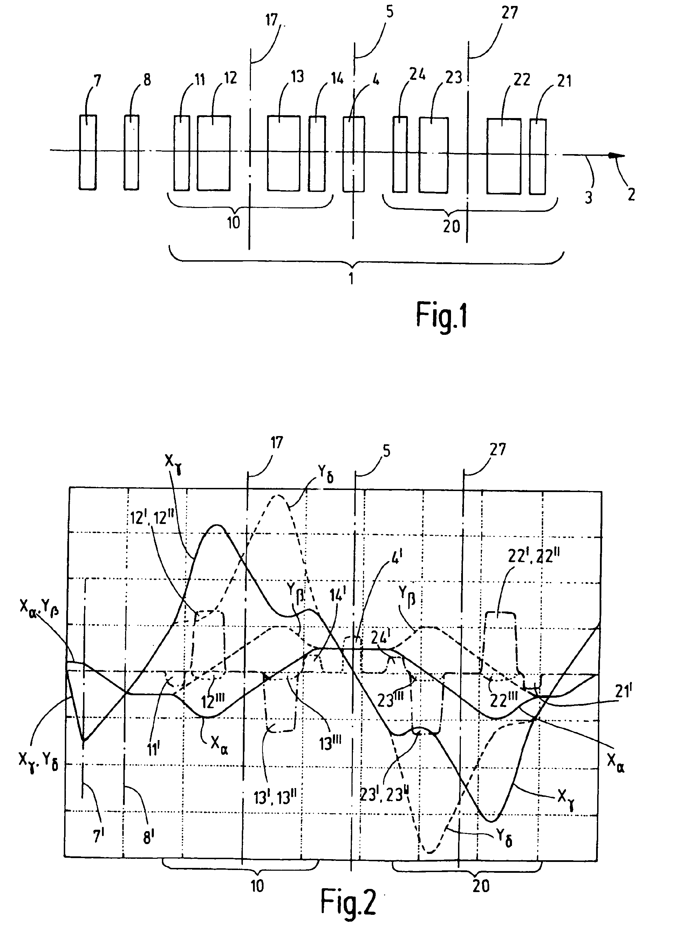

Identische Bezugszeichen zeigen immer identische Teile, Feldverläufe usw. Dabei betreffen alle Bezugszeichen zwischen 11 und 19 das erste Korrekturstück 10 und alle Bezugszeichen zwischen 21 und 28 das zweite Korrekturstück 20. Das Korrekturstück 10 weist Multipolelemente 11, 12, 13, 14 auf und das Korrekturstück 20 Multipolelemente 21, 22, 23, 24. Multipolelemente mit gleichen Endziffern sind baugleich und erzeugen bezüglich der Grundfunktionen der Erfindung gemäß Fig. 2 gleiche Felder. Die in Fig. 1 ersichtliche umgekehrte Reihenfolge der Bezugsziffern, also bei Korrekturstück 10 erstes Multipolelement 11, zweites 12, drittes 13 und viertes 14 und bei Korrekturstück 20 erstes Multipolelement 24, zweites 23, drittes 22 und viertes 21, symbolisiert die Symmetrie zur Mittelebene 5 mit der umgekehrten Reihenfolge der Multipolelemente 24, 23, 22, 21 beim zweiten Korrekturstück 20 gegenüber dem ersten Korrekturstück 10. Die durch die vorgenannten Multipolelemente 11, 12, 13, 14; 24, 23, 22, 21 erzeugten Felder entsprechen dieser Systematik, sie haben die gleichen Ziffern wie das jeweils erzeugende Multipolelement, und sind mit Strichen bezeichnet. Dabei bezeichnet ein Strich die Quadrupolfelder 11', 12', 13', 14'; 24', 23', 22', 21', zwei Striche die elektrische Quadrupolfelder 12", 13"; 23", 22" und drei Striche die Oktupolfelder 12"', 13"'; 23"', , 22'" der Grundfunktion gem. Fig. 2. Feldbezeichnungen der Weiterbildungen weichen von dieser Systematik ab.

**Fig. 1** zeigt eine Prinzipdarstellung des Aufbaus des erfindungsgemäßen Korrektors 1 mit der optischen Achse 3 des Strahlengangs 2 und zwei vorgeordneten Transferlinsen 7 und 8. Der Korrektor 1 besteht aus zwei Korrekturstücken 10 und 20, die in ihrem Aufbau und ihrer Grundfunktion gemäß Fig. 2 die Symmetrie zu der Mittelebene 5 aufweisen. In dieser Mittelebene 5 befindet sich ein zentrales Multipolelement 4. Das Korrekturstück 10 weist vier Multipolelemente auf, ein erstes 11, ein zweites 12, ein drittes 13 und ein viertes 14. Das Korrekturstück 20 verfügt über identische Multipolelemente in umgekehrter Reihenfolge, nämlich ein erstes 24, ein zweites 23, ein drittes 22 und ein viertes 21. Die beiden Korrekturstücke 10 und 20 verfügen ihrerseits wieder über Symmetrieebenen 17 und 27, so daß sich folgende Multipole baugleich und bezüglich der Grundfunktion entsprechen, nämlich das erste 11 und das vierte 14 sowie das zweite 12 und das dritte 13 des ersten Korrekturstücks 10 und das erste 24 und das vierte 21 sowie das zweite 23 und das dritte 22 des zweiten Korrekturstücks 20. Auf diese Weise wird eine doppelte Symmetrie einerseits durch die Symmetrieebenen 17 und 27 und andererseits durch die Mittelebene 5 gebildet.

**Fig. 2** zeigt die zu Fig. 1 korrespondierenden Bahn- und Feldverläufe des erfindungsgemäßen Korrektors 1 in ihrer Grundfunktion, wobei zusätzlich die Lagen 7', 8' der Transferlinsen 7 und 8 gemäß einer Weiterbildung des Korrektors eingezeichnet sind. Auch die Lagen der Symmetrieebenen 17 und 27 sowie der Mittelebene 5 entsprechen der Fig. 1.

Durch die Multipolelemente 11, 12, 13, 14; 24, 23, 22, 21 werden folgende Felder erzeugt, die in oben genannter Weise korrespondieren: Die ersten und vierten Multipolelemente 11 und 14 sowie 24 und 21 erzeugen Quadrupolfelder 11', 14'; 24', 21'. Die zweiten und dritten Multipolelemente 12, 13; 23 und 22 erzeugen einerseits magnetische Quadrupolfelder 12', 13'; 23', 22' und andererseits elektrische Quadrupolfelder 12", 13"; 23", 22", welche in oben beschriebener Weise zusammenwirkend der Farbfehlerkorrektur dienen.

Diese Multipolelemente 12, 13; 23, 22 erzeugen weiterhin Oktupolfelder 12"', 13"'; 23"', 22"', die in oben genannter Weise der Öffnungsfehlerkorrektur dienen. Um auch einen Astigmatismus 3. Ordnung zu beseitigen, erzeugt ein in der Mittelebene 5 angeordnetes zentrales Multipolelement 4 ein Oktupolfeld 4'.

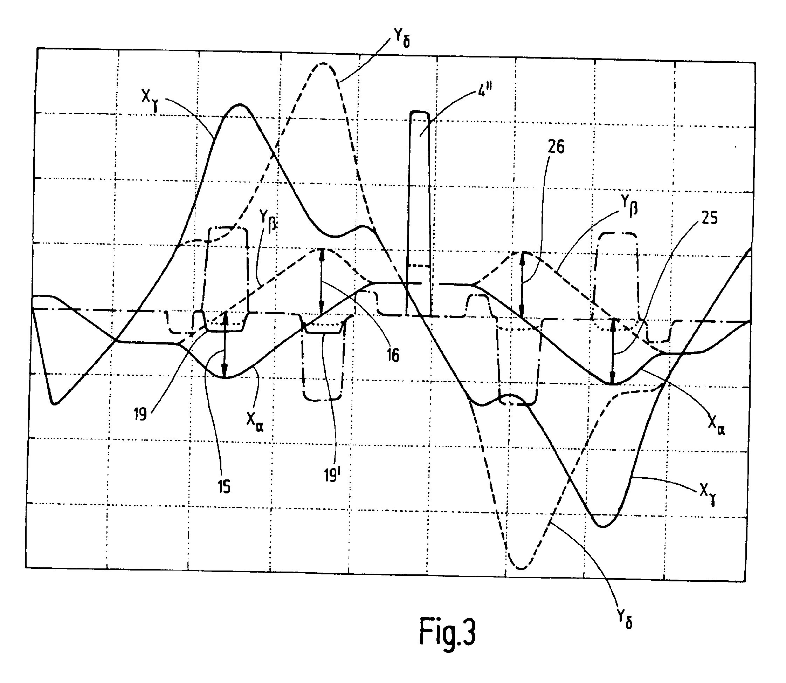

Mit Hilfe der Quadrupolfelder 11', 12', 13', 14'; 24', 23', 22', 21' werden die eingezeichneten Bahnverläufe erzielt. Dargestellt sind die Bahnverläufe in einer x- und einer y-Ebene. Die axiale Fundamentalbahnen genannten Bahnen x_{α} und y_{β} sind die Bahnen der Abbildung eines axialen Bildpunktes. Die außeraxiale Fundamentalbahnen genannten Bahnen x_{γ} und y_{δ} sind dagegen die Bahnen der Abbildung eines außeraxialen Bildpunktes. Wie ersichtlich, kommt es bei den axialen Fundamentalbahnen x_{α} und y_{β} durch das erste Quadrupolfeld 11' zu einem unterschiedlichen Verlauf der Strahlen des x- und y-Schnittes der zu einem astigmatischen Zwischenbild 15 im zweiten Multipolelement 12 führt (die astigmatischen Zwischenbilder 15, 16; 26, 25 sind zur Vermeidung einer Überfrachtung der Darstellung von Fig. 2 in Fig. 3 eingezeichnet). Durch eine Umlenkung von x_{α} mittels des zweiten zum ersten Quadrupolfeld 11' um 90° gedrehten Quadrupolfeldes 12' entsteht dann ein zweites astigmatisches Zwischenbild 16 im Multipolelement 13. In diesem werden wiederum durch eine 90°-Drehung des Quadrupolfeldes 13' die Fundamentalstrahlen x_{α} und y_{β} durch eine Umlenkung von y_{β} wieder aufeinander zugeführt, wobei die Fundamentalbahnen x_{α} und y_{β} durch das zum vorgenannten Quadrupolfeld 13' um 90° gedrehte Quadrupolfeld 14' wieder zu einem runden Strahl vereinigt werden. Derselbe Vorgang wiederholt sich im Korrekturstück 20 in spiegelsymmetrischer Weise.

Dabei können die Quadrupolfelder 11', 12', 13', 14'; 24', 23', 22', 21' elektrische oder magnetische Felder sein, wesentlich ist nur, daß die für die Farbfehlerkorrektur erforderlichen Quadrupolfelder 12", 13"; 23", 22" dann magnetisch sind, wenn die ersteren elektrisch sind oder umgekehrt. In der Nomenklatur der Darstellung wurden die Quadrupolfelder 12', 13'; 23', 22' als magnetisch und die Quadrupolfelder 12", 13"; 23", 22" als elektrisch definiert. Wesentlich sind diese zusammenwirkenden Felder für die Farbfehlerkorrektur in oben genannter Weise nach der o.g. Lehre von Scherzer.

Ebenfalls im Bereich der astigmatischen Zwischenbilder 15, 16; 26, 25 findet die Öffnungsfehlerkorrektur in oben beschriebener Weise ebenfalls nach der Lehre von Scherzer statt.

Die vorgenannten Korrekturen wären auch mittels eines der Korrekturstücke 10 oder 20 möglich. Daß in Symmetrie zur Mittelebene 5 zwei Korrekturstücke 10 und 20 mit umgekehrter Folge der Felder angeordnet sind, hat seinen Grund in der Wirkung des Korrektors bezüglich des Verlaufs der einen außeraxialen Punkt abbildenden Strahlen, welche als außeraxiale Fundamentalbahnen x_{γ} und y_{δ} eingezeichnet sind. Auch hier kommt es in ähnlicher Weise wie oben beschrieben zu unterschiedlichen Verläufen der Bahn x_{γ} in der x-Ebene und der Bahn y_{δ} in der y-Ebene mit Auftrennung dieser Fundamentalbahnen x_{γ} und y_{δ}, Umlenkungen und wieder Zusammenführungen durch die Quadrupolfelder 11', 12', 13', 14'; 24', 23', 22', 21', wie aus den Fig. 2, 3 und 4 ersichtlich. Im Unterschied zu den axialen Fundamentalbahnen x_{α} und y_{β} kommt es zu keiner Bildung von Zwischenbildern und es kommt bezüglich der Mittelebene 5 nicht zu einem symmetrischen, sondern zu einem antisymmetrischen oder punktsymmetrischen Bahnverlauf von x_{γ} und y_{δ}. Dadurch entstehen in den Korrekturstücken 10 und 20 bezüglich der außeraxialen Bahnen x_{γ} und y_{δ} im Hinblick auf Fehlerverursachungen entgegengesetzte Wirkungen. Dies hat zur Folge, daß fehlerverursachende Wirkungen auf Elektronen oder Ionen eliminiert werden, sofern diese die Korrekturstücke 10 und 20 in dieser antisymmetrischen Weise passieren.

Um einen hauptsächlich bei der Korrektur des Öffnungsfehlers 3. Ordnung erzeugten Astigmatismus 3. Ordnung zu korrigieren, sieht schließlich die Erfindung vor, daß durch das zentrale Multipolelement 4 ein Oktupolfeld 4' erzeugt wird, das genau dort wirkt, wo die außeraxialen Fundamentalbahnen x_{γ} und y_{δ} zu Null werden. Auf diese Weise wird vermieden, daß durch diese Korrektur wiederum andere außeraxiale Fehler erzeugt werden, da eine solche Fehlerverursachung im Achsbereich, in dem sich die kreissymmetrisch angeordneten Kraftfelder aufheben, nicht möglich ist.

**Fig. 3** zeigt dieselben Bahn- und Feldverläufe wie Fig. 2, jedoch mit zusätzlichen Zwölfpolfeldern 19, 19', 4", erzeugt durch das zweite und dritte Multipolelement 12 und 13 des ersten Korrekturstücks 10 und durch das zentrale Multipolelement 4. Der Grund für diese Anordnung besteht darin, daß axiale Fehler 5. Ordnung korrigiert werden sollen, die durch Öffnungsfehler 3. Ordnung da erzeugt werden, wo Oktupole 12"', 13"'; 23"', 22"' liegen. Da die Öffnungsfehler 3. Ordnung durch die Oktupolfelder 12"', 13"'; 23"', 22'' sukzessive reduziert werden, sind die durch die Öffnungsfehler 3. Ordnung erzeugten Fehler 5. Ordnung im ersten Korrektor 10 am größten, weil dort auch die Öffnungsfehler 3. Ordnung - da am wenigsten reduziert - noch am größten sind. Dies ist deshalb der günstigste Ort für eine Korrektur der Fehler 5. Ordnung, die bereits oben ausführlich erläutert wurde.

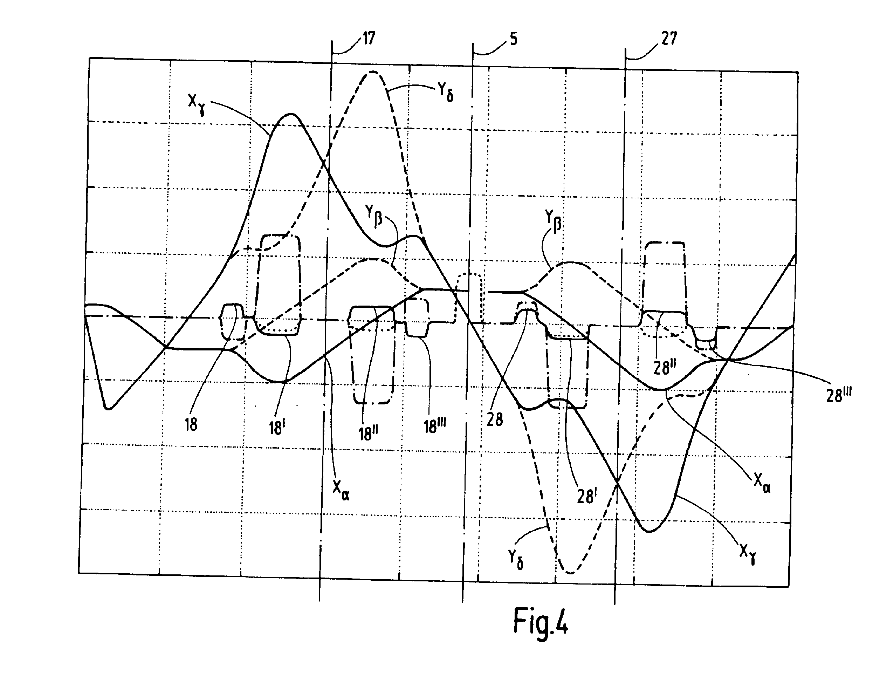

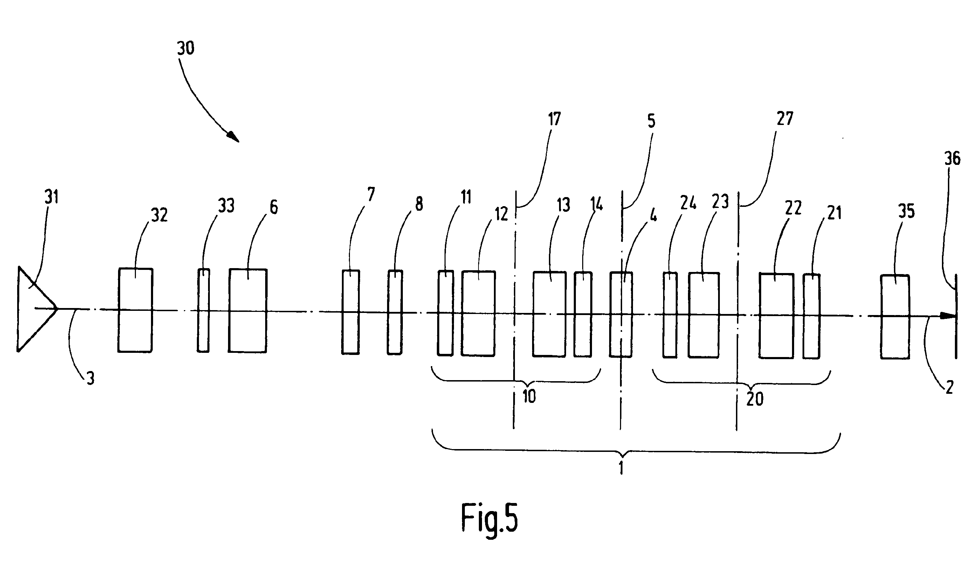

**Fig. 4** zeigt ebenfalls die vorgenannten Bahn- und Feldverläufe mit zusätzlichen Oktupolfeldern 18, 18', 18", 18"'; 28, 28', 28", 28'" auf allen Multipolen 11, 12, 13, 14; 24, 23, 22, 21, die Quadrupolfelder 11', 12', 13', 14'; 24', 23', 22', 21' erzeugen. Diese zusätzlichen Oktupolfelder 18, 18', 18", 18"'; 28, 28', 28", 28'" sind gegenüber den oben aufgeführten Oktupolfeldern 12"', 13"'; 23"', 22"', welche der Korrektur des Öffnungsfehlers dienen, um 22,5° verdreht, im Verhältnis zueinander jedoch in gleicher Ausrichtung. Die antisymmetrische Ausrichtung der Oktupolfelder 18, 18', 18", 18"'; 28, 28', 28", 28"' bezüglich der Symmetrieebenen 17, 27 der Korrekturstücke 10, 20 und bezüglich der Mittelebene 5 kann den gezeichneten Feldstärkenverlauf haben oder diese Verläufe können auch paarweise abwechselnd nach oben oder nach unten weisen. Mit den zusätzlichen Oktupolfeldern 18, 18', 18", 18"'; 28, 28', 28", 28"' wird die anisotrope Koma des Objektivs 34 (siehe Fig. 5) als dominanter außeraxialer Fehler korrigiert, ohne störende axiale oder außeraxiale Fehler einzuführen.
Die in den Figuren 2, 3, und 4 dargestellten Felder können wahlweise oder alle gleichzeitig erzeugt werden, um alle genannten Korrekturen vornehmen zu können; sie wurden nur der Übersichtlichkeit halber in verschiedenen Figuren dargestellt.

Die Figurenbeschreibungen dienen lediglich der Veranschaulichung der Erfindung, deshalb wird auf die weiter oben stehende ausführlicher Beschreibung der Erfindung und ihrer weiteren Ausgestaltungen verwiesen. Die Erfindung schließt dabei selbstverständlich nicht aus, daß noch weitere Felder, gegebenenfalls auch durch weitere Multipole erzeugt werden können, um zusätzlich noch weitere Fehler höherer Ordnungen zu korrigieren. Die Erfindung schließt auch nicht aus, daß die beschriebenen Korrekturen unvollständig vorgenommen werden, um unter Inkaufnahme solcher Nachteile beispielsweise mehr Bildpunkte zu erzielen. Wie erwähnt, kann man sich einer völligen Korrektur verschiedener Fehler immer nur annähern, ohne daß dies hundertprozentig möglich ist.

**Fig. 5** zeigt ein Elektronenmikroskop 30, in das der erfindungsgemäße Korrektor 1 mit den Transferlinsen 7 und 8 eingebaut ist. Der Strahlengang 2 geht dabei von einer Strahlquelle 31 aus, wird von einem Kondensor 32 gebündelt, um ein Objekt 33 zu durchstrahlen. Der Bilderzeugung dient das Objektiv 6 und gegebenenfalls eine Projektivlinse 35, wobei der Korrektor 1 und gegebenenfalls die Zwischenlinsen 7, 8 zwischen Objektivlinse 6 und Projektivlinse 35 liegen. Auf letztere könnte auch verzichtet werden. Das Bild wird dann auf einen Bildschirm 36 abgebildet oder die Bildpunkte zur Darstellung auf einem Bildschirm elektronisch erfaßt.

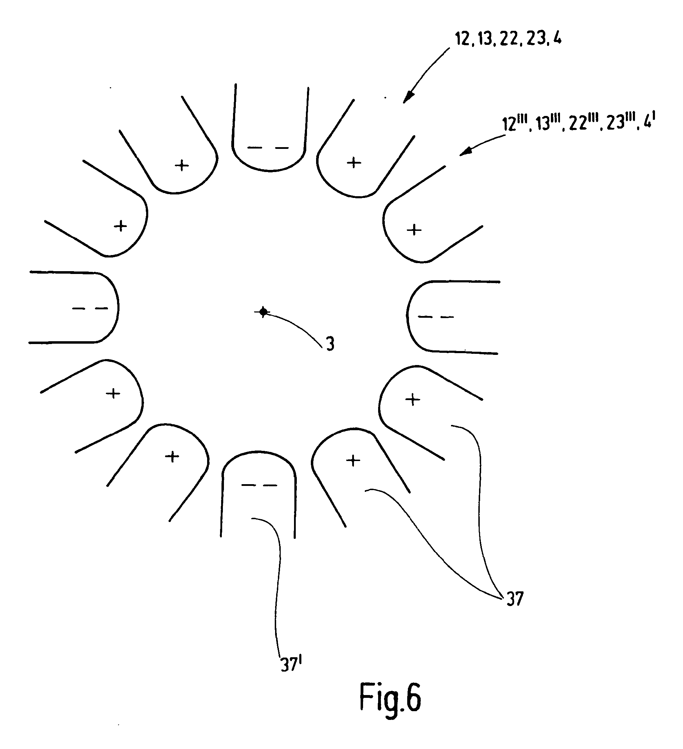

**Fig. 6** zeigt eine schematische Darstellung eines Zwölfpolelements, wobei es sich um die zweiten 12, 23 oder dritten Multipolelemente 13, 22, das zentrale Multipolelement 4 oder auch weitere Multipolelemente handeln kann. Die zwölf Pole 37, 37' sind achssymmetrisch um die optische Achse 3 angeordnet. Wird damit ein Zwölfpolfeld erzeugt, so sind die Pole 37, 37'der Reihe nach immer abwechselnd als Nord- und Südpole zur Erzeugung von magnetischen Feldern oder als negativ und positiv geladene Elektroden zur Erzeugung von elektrischen Feldern ausgebildet.

Soll eine Kombination eines elektrischen und eines magnetischen Feldes erzeugt werden, so dienen die Weicheisenkerne der Elektromagneten gleichzeitig als Elektroden, die mit einer Spannung beaufschlagt sind.

Soll ein Quadrupolfeld erzeugt werden, so sind immer drei Elektromagneten oder Elektroden 37, 37' mit gleicher Polarität oder Ladung zusammengefaßt und die Dreiergruppen wechseln als Nord- und Südpole oder als negativ beziehungsweise positiv geladene Elektroden ab. Auch dabei können elektrische und magnetische Felder überlagert sein. Eine solche Überlagerung kann einer Verstärkung dienen oder einem derartigen Zusammenwirken, daß in der Art eines Wienfilters in oben beschriebener Weise durch magnetische und elektrische Felder eine Farbfehlerkorrektur erzielt ist.

Sollen dagegen Oktupolfelder 12"', 13"'; 23"', 22"'; 18, 18', 18", 18"'; 28, 28', 28", 28''''; 4' erzeugt werden, so müssen sich die Pole 37, 37'wie durch die "+" und "-" Zeichen dargestellt, abwechseln. Es folgen also zwei positiv geladene Elektroden 37 und eine negativ geladene Elektroden 37' - oder umgekehrt - in abwechselnder Reihe, wobei die negative Ladung (wie durch die zwei "-" Zeichen symbolisiert) entsprechend verstärkt sein muß, um ein möglichst unverzerrtes Oktupolfeld zu erzielen. Bei der Erzeugung eines magnetischen Oktupols verhält sich dies dann entsprechend.

Überlagerte Felder, wie Quadrupolfeld, Oktupolfeld und Zwölfpolfeld, erzeugt durch ein einziges Zwölfpolelement erhält man dadurch, daß in den jeweiligen Polen - also in den Elektromagneten oder Elektroden - die Ströme bzw. Spannungen aufsummiert werden. Auf diese Weise lassen sich alle oben erwähnten Feldüberlagerungen herstellen, auch zwei Oktupolfelder, die gegeneinander um 22,5° verdreht sind.

Dabei können Feldüberlagerungen auch durch sich überlagernde magnetische und elektrische Felder ausgerührt werden, um Feldabschwächungen durch Überlagerung entgegengesetzter Polaritäten zu vermeiden.

Natürlich ist es auch möglich, Multipole mit einer höheren Polanzahl einzusetzen, um eine exaktere Teilung der Felder zu erzielen. Auch ist es möglich, zur Erzeugung von verschiedenen Feldern, die nicht unbedingt exakt am selben Ort wirken müssen, Multipole verschiedener Teilungen aneinanderfügt anzuordnen.

### Bezugszeichenliste

- 1: Korrektor
- 2: Strahlengang
- 3: optische Achse
- 4: zentrales Multipolelement
- 4': Oktupolfeld des zentralen Multipolelements
- 4": Zwölfpolfeld des zentralen Multipolelements
- 5: Mittelebene
- 6: Objektivlinse
- 7, 8: Transferlinsen
- 7', 8': Lage der Transferlinsen
- 10: erstes Korrekturstück
- 11, 12, 13, 14: erstes, zweites, drittes und viertes Multipolelement des ersten Korrekturstücks
- 11', 14': Quadrupolfelder des ersten und vierten Multipolelements
- 12', 13': magnetische Quadrupolfelder des zweiten und dritten Multipolelements
- 12", 13": elektrische Quadrupolfelder des zweiten und dritten Multipolelements
- 12"', 13"': Oktupolfelder des zweiten und dritten Multipolelements
- 15: astigmatisches Zwischenbild des axialen Strahlengangs im zweiten Multipolelement
- 16: astigmatisches Zwischenbild des axialen Strahlengangs im dritten Multipolelement
- 17: Symmetrieebene des ersten Korrekturstücks
- 18, 18', 18", 18"': Oktupolfelder, die gegenüber den Oktupolfeldern 12"', 13"' um 22,5° verdreht sind
- 19: Zwölfpolfeld des zweiten Multipolelements
- 19': Zwölfpolfeld des dritten Multipolelements
- 20: zweites Korrekturstück
- 24, 23, 22, 21: erstes, zweites, drittes und viertes Multipolelement des zweiten Korrekturstücks
- 24', 21': Quadrupolfelder des ersten und vierten Multipolelements
- 23', 22': magnetische Quadrupolfelder des zweiten und dritten Multipolelements
- 23", 22": elektrische Quadrupolfelder des zweiten und dritten Multipolelements
- 23"', 22"': Oktupolfelder des zweiten und dritten Multipolelements
- 25: astigmatisches Zwischenbild des axialen Strahlengangs im dritten Multipolelement
- 26: astigmatisches Zwischenbild des axialen Strahlengangs im zweiten Multipolelement
- 27: Symmetrieebene des zweiten Korrekturstücks
- 28, 28', 28", 28"': Oktupolfelder, die gegenüber den Oktupolfeldern 23"', 22"' um 22,5° verdreht sind.
- 30: Elektronenmikroskop (Prinzipskizze)
- 31: Strahlquelle
- 32: Kondensor
- 33: Objekt
- 35: Projektivlinse
- 36: Bildschirm
- 37: Pol als Elektromagnet und/oder Elektrode (Südpol oder positiv geladene Elektrode)
- 37': Pol als Elektromagnet und/oder Elektrode (Nordpol oder negativ geladene Elektrode)
- x_{α}, y_{β}: Fundamentalbahnen des axialen Strahlengangs
- x_{γ} , y_{δ}: Fundamentalbahnen des außeraxialen Strahlengangs

## Patentansprüche

1. Korrektor (1) für den axialen und außeraxialen Strahlengang eines teilchenoptischen Systems mit einem ersten (10) und einem zweiten (20) Korrekturstück, die im Strahlengang (2) auf einer optischen Achse (3) nacheinander angeordnet sind, wobei jedes Korrekturstück (10, 20) vier nacheinander angeordnete Multipolelemente (11, 12, 13, 14; 24, 23, 22, 21) mit den folgenden Feldern in einer Symmetrie zu einer Mittelebene (5) aufweist, wobei von den Multipolelementen (11, 12, 13, 14; 24, 23, 22, 21) das erste (11; 24) und das vierte (14; 21) zur Erzeugung von Quadrupol-feldern (11', 14'; 24', 21') und das zweite (12; 23) und dritte (13; 22) zur Erzeugung von Oktupolfeldern (12"', 13"'; 23"', 22"') und von Quadrupolfeldern (12', 13'; 23', 22') dienen, wobei letztere übereinandergelagerte magnetische (12', 13'; 23', 22') und elektrische Felder (12", 13"; 23", 22") sind und wobei die Quadrupol-felder (11', 12', 13', 14'; 24', 23', 22', 21') aller vier Multipolelemente (11, 12, 13, 14; 24, 23, 22, 21) von einem zum nächsten um 90° gedreht sind, so daß mittels astigmatischer Zwischenbilder (15, 16; 26, 25) im zweiten und dritten Multipolelement (12, 13; 23, 22) durch das Zusammenwirken der magnetischen (12', 13'; 23', 22') und elektrischen Felder (12", 13"; 23", 22") eine Farbfehlerkorrektur und mittels der Quadrupolfelder (12', 13'; 23', 22') und der Oktupolfelder (12"', 13"'; 23"', 22"') eine Öffnungsfehlerkorrektur möglich ist, und wobei
ein in der Mittelebene (5) liegendes zentrales Multipolelement (4) ein
Oktupolfeld (4') zur Beseitigung des Astigmatismuses 3.Ordnung erzeugt.

2. Korrektor nach Anspruch 1,
**dadurch gekennzeichnet,**
**daß** zur Korrektur der Fehler 5. Ordnung mittels der zweiten und dritten Multipolelemente (12, 13) des ersten Korrekturstücks (10) sowie des zentralen Multipolelements (4) Zwölfpolfelder (19, 19', 4") erzeugt werden.

3. Korrektor nach Anspruch 2,
**dadurch gekennzeichnet,**
**daß** mit jeweils einem der Zwölfpolfelder (19, 19', 4) der Sternfehler 5. Ordnung, der Rosettenfehler 5. Ordnung und der Astigmatismus 5. Ordnung korrigiert werden.

4. Korrektor nach Anspruch 1, 2 oder 3,
**dadurch gekennzeichnet,**
**daß** zur Korrektur der anisotropen Koma der Objektivlinse (6) mittels der Multipolelemente (11, 12, 13, 14; 24, 23, 22, 21), welche die Quadrupolfelder (11', 12', 13', 14'; 24', 23', 22', 21') erzeugen, weitere Oktupolfelder (18, 18', 18", 18'"; 28, 28', 28", 28'") erzeugt werden, die gegenüber den Oktupolfeldern (12"', 13"'; 23"', 22"') zur Öffnungsfehlerkorrektur um 22,5° verdreht sind und wobei die Oktupolfeldstärken bezüglich der Symmetrieebenen (17; 27) der Korrekturstücke (10, 20) und bezüglich der Mittelebene (5) antisymmetrisch sind.

5. Korrektor nach einem der Ansprüche 1 bis 4,
**dadurch gekennzeichnet,**
**daß** mindestens die zweiten und dritten Multipolelemente (12, 13; 23, 22) des ersten und zweiten Korrekturstücks (10, 20) und das zentrale Multipolelement (4) Zwölfpolelemente sind, welche durch eine Steuerung unterschiedliche Felder bis zu Zwölfpolfeldern, einschließlich Überlagerungen unterschiedlicher Felder, durch entsprechende Strom- und/oder Spannungsbeaufschlagung erzeugen können.

6. Korrektor nach einem der Ansprüche 1 bis 5,
**dadurch gekennzeichnet,**
**daß** dem Korrektor (1) objektivseitig zwei als Rundlinsen ausgebildete Transferlinsen (7, 8) zugeordnet sind, durch deren Feldeinstellung Öffnungsfehler 5. Ordnung und/oder die radiale Koma 3. Ordnung beseitigbar oder auf ein tolerierbares Maß reduzierbar sind.

7. Korrektor nach Anspruch 6,
**dadurch gekennzeichnet,**
**daß** eine Nachjustierung der Quadrupol- (12', 13', 12", 13"; 23', 22', 23", 22") und Oktupolfelder (12"', 13"'; 23"', 22"') des zweiten und dritten Multipolelements (12, 13; 23, 22) des ersten und zweiten Korrekturstücks (10, 20) und des Oktupolfeldes (4') des zentralen Multipolelements (4) möglich ist, derart daß durch die vorgenannte Einstellung der Transferlinsen (7, 8) erneut verursachte Farbfehler erster und Öffnungsfehler dritter Ordnung wieder beseitigt werden.

8. Korrektor nach Anspruch 7,
**dadurch gekennzeichnet,**
**daß** eine Nachjustierung der Zwölfpolfelder (19, 19') des zweiten (12) und dritten Multipolelements (13) des ersten Korrektors (10) und des Zwölfpolfeldes (4") des zentralen Multipolelements (4) möglich ist, um die durch die Transferlinsen (7, 8) und die vorgenannte Nachjustierung wiederaufgetretenen Fehler höherer Ordnung wieder zu beseitigen.

9. Korrektor nach Anspruch 6, 7 und 8,
**dadurch gekennzeichnet,**
**daß** eine Beseitigung der durch Fehlerkorrekturen wieder aufgetretenen Farbfehler erster und Öffnungsfehler dritter sowie Fehler höherer Ordnung durch eine Nachjustierung von Transferlinsen (7, 8), Quadrupolfeldern (12', 13', 12", 13"; 23', 22', 23", 22") des ersten und zweiten Korrekturstücks (10, 20) und Oktupolfeldern (12"', 13'"; 23"', 22"'; 4') des ersten und zweiten Korrekturstücks (10, 20) sowie des zentralen Multipolelements (4), danach von Zwölfpolfeldern (19, 19', 4") des ersten Korrekturstücks (10) sowie des zentralen Multipolelements (4) und dann der weiteren Oktupolfelder (18, 18', 18", 18"'; 28, 28', 28", 28"') aller Quadrupolfelder (11', 12', 13', 14'; 24', 23', 22', 21') erzeugenden Multipolelemente (11, 12, 13, 14; 24, 23, 22, 21) sowie eine iterative Einstellung in den vorgenannten Schritten zur Verminderung der durch die jeweils vorangegangenen Nachjustierungen wiederum verursachten Fehler möglich sind, bis diese auf eine für die gewünschte Bildgebung tolerierbare Größe reduziert sind.

10. Korrektor nach einem der Ansprüche 1 bis 9,
**dadurch gekennzeichnet,**
**daß** durch Zulassung eines kleinen Öffnungsfehlers 5. Ordnung eine Bildauflösung bis zu etwa 10.000 Bildpunkten längs eines Bilddurchmessers erzielbar ist.

11. Transmissionselektronenmikroskop,
**gekennzeichnet durch**
eine Korrektur des Elektronenstrahls mittels eines Korrektors (1) nach einem der Ansprüche 1 bis 10.

## Claims

1. Corrector (1) for the axial and off-axis beam path of a particle-optical system comprising a first (10) and a second (20) corrector piece that are successively arranged in a beam path (2) on an optical axis (3), wherein each corrector piece (10, 20) has four multipole elements (11, 12, 13, 14; 24, 23, 22, 21) arranged successively with the following fields arranged symmetrically about a central plane (5), wherein of the multi-pole elements (11, 12, 13, 14; 24, 23, 22, 21) the first (11; 24) and the fourth (14; 21) are used for generating quadrupole fields (11', 14'; 24', 21') and the second (12; 23) and third (13; 22) for generating octupole fields (12"', 13"'; 23"', 22"') and quadrupole fields (12', 13'; 23', 22'), wherein the latter are superimposed magnetic (12', 13'; 23', 22') and electric fields (12", 13"; 23", 22") and wherein the quadrupole fields (11', 12', 13', 14'; 24', 23', 22', 21') of all four multi-pole elements (11, 12, 13, 14; 24, 23, 22, 21) are rotated by 90° from one to the next, so that by means of astigmatic intermediate images (15, 16; 26, 25) in the second and third multi-pole element (12, 13; 23, 22) due to the interaction of the magnetic (12', 13'; 23', 22') and electric fields (12", 13"; 23", 22"), a colour error correction is possible and by means of the quadrupole fields (12', 13'; 23', 22') and the octupole fields (12"', 13"'; 23"', 22"') an aperture error correction is possible, and wherein a central multi-pole element (4) which lies in the central plane (5) generates an octupole field (4') for eliminating the third-order astigmatism.

2. Corrector according to Claim 1, **characterized in that** to correct the fifth order error using the second and third multi-pole elements (12, 13) of the first corrector piece (10) and of the central multi-pole element (4), dodecapole fields (19, 19', 4") are generated.

3. The corrector according to Claim 2, **characterized in that** the fifth-order error star aberration, the fifth-order rosette aberration and the fifth-order astigmatism are corrected with in each case one of the dodecapole fields (19, 19', 4).

4. Corrector according to Claim 1, 2 or 3, **characterized in that** to correct the anisotropic coma of the objective lens (6), which is generated by the quadrupole fields (11', 12', 13', 14'; 24', 23', 22', 21'), by means of the multi-pole elements (11, 12, 13, 14; 24, 23, 22, 21), additional octupole fields (18, 18', 18", 18"'; 28, 28', 28", 28'") are generated that are rotated by 22.5° relative to the octupole fields (12"', 13"'; 23"', 22'") for aperture error correction and wherein the octupole field strengths are antisymmetric with respect to the planes of symmetry (17; 27) of the corrector pieces (10, 20) and with respect to the central plane (5).

5. Corrector according to any one of Claims 1 to 4, **characterized in that** at least the second and third multi-pole elements (12, 13; 23, 22) of the first and second corrector piece (10, 20) and the central multipole element (4) are dodecapole elements, which can generate different fields up to dodecapole fields by means of a control unit, including superpositions of different fields, by corresponding application of current and/or voltage.

6. Corrector according to any one of Claims 1 to 5, **characterized in that** on the objective side the corrector (1) is assigned two transfer lenses (7, 8), implemented as round lenses, the field settings of which can be used to eliminate the fifth-order aperture errors and/or the third-order radial coma or reduce them to a tolerable level.

7. Corrector according to Claim 6, **characterized in that** a readjustment of the quadrupole (12', 13', 12", 13", 23", 22", 23", 22") and octupole fields (12', 13'; 23', 22') of the second and third multi-pole element (12, 13; 23, 22) of the first and second corrector piece (10, 20) and of the octupole field (4') of the central multipole element (4) is possible, in such a manner that any first-order colour defects and third-order aperture errors reintroduced by the aforementioned setting of the transfer lenses (7, 8) are again eliminated.

8. Corrector according to Claim 7, **characterized in that** a readjustment of the dodecapole fields (19, 19 ') of the second (12) and third multipole element (13) of the first corrector (10) and of the dodecapole field (4") of the central multipole element (4) is possible, in order to eliminate again the higher-order errors introduced by the transfer lenses (7, 8) and the above mentioned readjustment.

9. The corrector according to Claim 6, 7 or 8, **characterized in that** elimination of the first-order colour errors and third-order aperture errors reintroduced by the error corrections and of the higher order errors due to a readjustment of transfer lenses (7, 8), of quadrupole fields (12', 13', 12", 13"; 23', 22', 23", 22") of the first and second corrector piece (10, 20) and of octupole fields (12"', 13"'; 23"', 22"'; 4') of the first and second corrector piece (10, 20), and of the central multipole element (4), thereafter of dodecapole fields (19, 19', 4") of the first corrector piece (10) and of the central multi-pole element (4) and then of the additional octupole fields (18, 18', 18", 18"'; 28, 28', 28", 28"') of all multi-pole elements (11, 12, 13, 14; 24, 23, 22, 21) generating quadrupole fields (11', 12', 13', 14'; 24', 23', 22', 21'), and an iterative adjustment in the aforementioned steps to reduce the errors caused in turn by the respective preceding readjustments are possible, until these are reduced to a level which is tolerable for the desired imaging.

10. Corrector according to any one of Claims 1 to 9, **characterized in that** by permitting a small fifth-order aperture error an image resolution of up to approximately 10,000 pixels along an image diameter can be achieved.

11. Transmission electron microscope, **characterized by** a correction of the electron beam by means of a corrector (1) according to any one of Claims 1 to 10.

## Revendications

1. Correcteur (1) pour la trajectoire de faisceau axiale et extra-axiale d'un système optique à particules avec une première (10) et une deuxième (20) pièce de correction qui sont disposées l'une derrière l'autre dans la trajectoire de faisceau (2) sur un axe optique (3), pour lequel chaque pièce de correction (10, 20) comporte quatre éléments multipolaires (11, 12, 13, 14; 24, 23, 22, 21) disposés les uns derrière les autres avec des champs successifs dans une symétrie par rapport à un plan médian (5), pour lequel des éléments multipolaires (11, 12, 13, 14 ; 24, 23, 22, 21), le premier (11 ; 24) et le quatrième (14 ; 21) servent à la production des champs quadripolaires (11', 14' ; 24', 21') et le deuxième (12 ; 23) et le troisième (13 ; 22) servent à la production de champs octopolaires (12''', 12"' ; 23"', 22"') et des champs quadripolaires (12', 13' ; 23', 22'), pour lequel les derniers sont des champs magnétiques (12', 13' ; 23', 22') et électriques (12", 13", 23", 22) superposés et pour lequel les champs quadripolaires (11', 12', 13', 14' ; 24', 23', 22', 21') de tous les quatre éléments multipolaires (11, 12, 13, 14 ; 24, 23, 22, 21) sont tournés de 90° l'un par rapport au suivant de sorte qu'une correction de défaut chromatique est possible au moyen d'images intermédiaires astigmatiques (15, 16 ; 26, 25) dans le deuxième et troisième élément multipolaire (12, 13 ; 23, 22) par action conjointe des champs magnétiques (12', 13' ; 23, 22') et électriques (12", 13" ; 23", 22") et une correction de défaut d'ouverture au moyen des champs quadripolaires (12', 13' ; 23', 22') et des champs octopolaires (12"', 13"', 23"', 22"') et pour lequel un élément multipolaire (4) central se trouvant dans le plan médian (5) produit un champ octopolaire (4') pour éliminer l'astigmatisme de 3ème ordre.

2. Correcteur selon la revendication 1 **caractérisé en ce que** des champs dodécapolaires (19, 19', 4") sont produits pour la correction des défauts de 5ème ordre au moyen des deuxième et troisième éléments multipolaires (12, 13) de la première pièce de correction (10) ainsi que de l'élément multipolaire central (4).

3. Correcteur selon la revendication 2 **caractérisé en ce que** pour le défaut stellaire de 5ème ordre, le défaut de rosette du 5ème ordre et l'astigmatisme de 5ème ordre sont corrigés avec respectivement un des champs dodécapolaires (19, 19', 4).

4. Correcteur selon la revendication 1, 2 ou 3 **caractérisé en ce que** d'autres champs octopolaires (18, 18', 18", 18'" ; 28, 28', 28", 28''') sont produits au moyen des éléments multipolaires (11, 12, 13, 14 ; 24, 23, 22, 21), lesquels produisent les champs quadripolaires (11', 12', 13', 14' ; 24', 23', 22', 21'), qui sont tournés de 22,5° vis-à-vis des champs octopolaires (12"', 13'" ; 23'", 22''') pour la correction de défaut d'ouverture et pour lequel les intensités de champ octopolaire sont antisymétriques en ce qui concerne les plans de symétrie (17; 27) des pièces de correction (10, 20) et en ce qui concerne le plan médian (5).

5. Correcteur selon l'une quelconque des revendications 1 à 4 **caractérisé en ce qu'**au moins les deuxième et troisième éléments multipolaires (12, 13 ; 23, 22) de la première et deuxième pièce de correction (10, 20) et l'élément multipolaire (4) sont des éléments dodécapolaires, lesquels peuvent produire par un pilotage, différents champs jusqu'à des champs dodécapolaires, y compris des superpositions de champs différents, par application de courant et/ou de tension correspondante.

6. Correcteur selon l'une quelconque des revendications 1 à 5 **caractérisé en ce que** deux lentilles de transfert (7, 8) constituées du côté objectif comme des lentilles circulaires sont attribuées au correcteur (1), au moyen desquelles le défaut d'ouverture de 5ème ordre et/ou le coma radial de 3ème ordre peuvent être éliminés ou réduits à une mesure tolérable.

7. Correcteur selon la revendication 6 **caractérisé en ce qu'**un réajustage des champs quadripolaires (12', 12', 12", 13" ; 23', 22', 23", 22") et octopolaires (12"', 13'" ; 23"', 22"') du deuxième et troisième élément multipolaire (12, 13 ; 23, 22) de la première et deuxième pièce de correction (10, 20) et du champ octopolaire (4') de l'élément multipolaire central (4) est possible de telle manière que les défauts chromatiques à nouveau causés sont à nouveau éliminés par le réglage précité des lentilles de transfert (7, 8).

8. Correcteur selon la revendication 7 **caractérisé en ce qu'**un réajustage des champs dodécapolaires (19, 19') du deuxième (12) et troisième élément multipolaire (13) du premier correcteur (10) et du champ dodécapolaire (4") de l'élément multipolaire central (4) est possible pour à nouveau éliminer les défauts d'ordre supérieur réapparus par les lentilles de transfert (7, 8) et le réajustage précité.

9. Correcteur selon la revendication 6, 7 et 8 **caractérisé en ce qu'**il est possible d'éliminer les défauts chromatiques à nouveau survenus par les corrections de défaut de premier ordre et les défauts d'ouverture de troisième ordre ainsi que les défauts d'ordre supérieur par un réajustage des lentilles de transfert (7, 8), les champs quadripolaires (12', 13', 12", 13" ; 23', 22', 23", 22") de la première et de la deuxième pièce de correction (10, 20) et les champs octopolaires (12"', 13"' ; 23"', 22"' ; 4') de la première et de la deuxième pièce de correction (10, 20) ainsi que de l'élément multipolaire central (4), puis des champs dodécapolaires (19, 19' ; 4") de la première pièce de correction (10) ainsi que de l'élément multipolaire central (4) et ensuite des autres champs octopolaires (18, 18', 18", 18"' ; 28, 28', 28", 28"') de tous les éléments multipolaires (11, 12, 13, 14 ; 24, 23, 22, 21) produisant des champs quadripolaires (11', 12', 13', 14' ; 24', 23', 22', 21') ainsi que d'effectuer un réglage itératif dans les phases précitées pour réduire les défauts à nouveau causés par les réajustages respectifs précédents jusqu'à ce que ceux-ci soient réduits à une valeur tolérable pour l'imagerie souhaitée.

10. Correcteur selon l'une quelconque des revendications 1 à 9 **caractérisé en ce qu'**une résolution d'image allant jusqu'à environ 10 000 points d'image le long d'un diamètre d'image peut être atteinte par autorisation d'un petit défaut d'ouverture du 5ème ordre.

11. Microscope électronique de transmission **caractérisé par** une correction du faisceau électronique au moyen d'un correcteur (1) selon l'une quelconque des revendications 1 à 10.
